# EUROPEAN PATENT SPECIFICATION

(11) **EP 3 147 709 B1**
(45) Date of publication and mention of the grant of the patent: **13.06.2018**
(21) Application number: 15186316.4
(22) Date of filing: 22.09.2015
(51) Int. Cl.: G03F 7/20, G03F 7/40

(54) **METHOD FOR PRODUCING A PRINTING PLATE FOR FLEXOGRAPHIC PRINTING, AND A RAW PRINTING PLATE**
VERFAHREN ZUR HERSTELLUNG EINER DRUCKPLATTE FÜR FLEXODRUCK UND ROHDRUCKPLATTE
PROCÉDÉ DE PRODUCTION D'UNE PLAQUE D'IMPRESSION POUR IMPRESSION FLEXOGRAPHIQUE ET PLAQUE D'IMPRESSION BRUTE

(43) Date of publication of application: 29.03.2017
(73) Proprietor: Tetra Laval Holdings & Finance S.A., 1009 Pully (CH)
(72) Inventor: Tarczal, Ferenc, 22478 LUND (SE); Ren, Kai, 24770 GENARP (SE)
(74) Representative: Tetra Pak - Patent Attorneys SE

(56) References cited:
- EP-A1- 2 738 606
- WO-A1-2012/145111
- WO-A1-2014/031146
- WO-A1-2014/031329

## Description

### Technical field

The invention relates to a method for producing a printing plate for flexographic printing, and a raw printing plate ready to be made into a printing plate for flexographic printing, as well as to an improved method of printing a substrate including adjusting the print quality, by using the printing plate of the invention.

### Background art

Flexographic printing has been used for a long time for large scale printing, e.g. printing on packaging material for packages. The printing process has to be fast to keep up with automated packaging systems of goods, e.g. in the food industry. Flexographic printing utilizes a flexible relief plate that is placed around a cylinder. The relief print pattern is rolled along with the cylinder on the material that is printed upon.

A flexographic print is thus made by creating a positive mirrored master of the required image as a 3D relief in a rubber or polymer material. Flexographic plates are traditionally created with analogue and digital plate making processes. The image areas are raised above and protruding from the non-image areas on the rubber or polymer plate. The ink is transferred from the ink roll, which is partially immersed in the ink tank, to the anilox or ceramic roll (or meter roll), of which the texture holds a specific amount of ink since its surface is covered with thousands of small cells or cups that enable it to meter ink to the printing plate in a uniform thickness evenly and quickly. To avoid getting a final product with a smudgy or lumpy look, it must be ensured that the amount of ink on the printing plate is not excessive. This is achieved by using a scraper, called a doctor blade. The doctor blade removes excess ink from the anilox roller before inking the printing plate, which is mounted onto a print form roller or so called plate cylinder. The substrate is finally forwarded or placed between the plate and the impression cylinder to transfer the image. The substrate sheet may thus be fed forward through a roller nip formed between the impression cylinder and the plate cylinder. The sheet is then fed through a dryer, which allows the inks to dry by forced evaporation of solvents or liquid medium, before the surface is touched again. If UV-curing ink is used, the sheet does not have to be dried, but the ink is cured by UV rays instead.

Flexographic plates are commonly made using a light-sensitive polymer, a photopolymer. A light stopping negative is placed over the plate, which is exposed to ultra-violet light. The polymer hardens where light passes through the light stopping negative. The non-irradiated, not hardened polymer is still softer and un-crosslinked and may have a consistency of chewed gum. It is washed away by water or solvent. Brushes scrub the plate to facilitate the "washout" process. The process can differ depending on whether solid sheets of photopolymer or highly viscous liquid photopolymer are used, but the principle is still the same.

The light stopping negative is in state of the art equipment made by covering the entire polymer plate with a carbon layer and then burning away carbon in the pattern that is to form the relief pattern, i.e. the pattern of the final printed pattern, by using a laser. The advantage of using a laser for creating the negative is that a very accurate printed negative with a resolution of about 10 µm may be facilitated. A typical method for processing a flexographic printing plate including the use of laser ablating of a carbon layer to form an in situ mask is dislcosed in EP 2 738 606 A1.

When exposing the negative and the underlying polymer plate to UV-light, the polymer will harden underneath the negative at places where the UV-light can penetrate, enabling the creation of a relief in a positive image compared to the negative. UV-light will however not only expose the parts of the polymer that are directly underneath in the normal direction to the surface area of the "open" parts of the negative. UV-light will also to some extent penetrate into the polymer to the sides of the "open" parts of the negative pattern, slightly hardening the polymer in the edges of the relief pattern. This effect is gradually decreasing with distance from the "open parts" leading to shoulder parts on the relief decreasing linearly in height. If the relief is to print a dot, the negative thus being a hole, the polymer plate will have a cone-shape relief in 3D, i.e. a dot with linearly decreasing shoulders.

The shoulders of the relief pattern leads to problems in the printing process. When pressing the relief against the material that is to be printed, the relief will be slightly compressed and the shoulders will start to touch the material to be printed, giving rise to an extension of the surface of the printed pattern, beyond the surface of the relief pattern on the print plate, such surface extension being referred to as dot gain. The dot gain will be proportional to the pressure of the relief onto the material that is to be printed.

The operator operating the flexographic printing machine has to adjust the pressure each time a new relief is placed on a cylinder in the machine or as the relief that is used is worn. When adjusting the pressure, the operator has to choose a pressure, or distance between the cylinder and the material to be printed, that is high enough so that the print is printed in every point of the print pattern but that is low enough so that the dot-gain is not too big. If the pressure is too high, the dot gain will lead to that e.g. two parallel lines will float together and form a single thick line instead.

To give the operator a visual feedback, a marking with fine patterns may be placed in the relief. The operator may then look at the marking on the printed surface and adjust the machine to avoid dot gain. These markings are however a very coarse measure for the operator. The worst effects of dot-gain may be avoided, but a moderate dot-gain will not be able to distinguish. This leads to a, to some extent, arbitrary adjustment of the flexographic printing machine and to an arbitrary dot gain and thereby to an unreliable printing result. There is thus a need for better and more accurate way for detecting dot-gain so that the flexographic printing machine may be better operated.

### Summary of the invention

It is an object of the present invention to improve the current state of the art, to solve the above problems, and to provide an improved printing plate for flexographic printing.

It is a further object of the invention to provide a printing method enabling better print quality control.

It is further an object to provide printed substrates and products having an improved and more reliable print quality.

According to a first aspect of the invention, these and other objects are achieved in full, or at least in part, by a method for producing a printing plate for flexographic printing from a raw printing plate, which raw printing plate comprises a photopolymer layer and a carbon layer. The method comprises the steps of creating a pattern in said raw printing plate by partly removing said carbon layer according to a desired pattern, exposing said carbon layer and underlying photopolymer layer to irradiation in order to harden said photopolymer layer in said pattern, and removing said remaining carbon layer and the portions of said photopolymer layer not exposed to irradiation. The method is characterised in that said pattern has at least one roughened edge. The at least one rough edge of said pattern causes the irradiation to reach a larger area on the photopolymer layer during the hardening process. In turn, the relief pattern formed on the photopolymer layer underneath the roughened edges will be provided with a shallower, longer shoulder and will thereby react much more sensitively to impression changes during use of the printing plate. The edge of the relief pattern corresponding to the roughened edges will thus be more sensitive to pressure variation between the printing plate and the substrate, which will accordingly be seen as better controllable level of dot gain

The at least one roughened edge may constituted by an edge portion of said pattern with a plurality of extension portions extending from said edge portion, wherein said plurality of extension portions may comprise lines extending in a direction substantially perpendicular to said edge. The lines on said edge will provide the corresponding side of the relief pattern formed on the photopolymer layer with a shallow shoulder.

In a preferred embodiment of the present invention, said lines each may have a width of 5-25 µm, preferably 10 µm, a length of 10-80 µm, preferably 40 µm, and be separated by a predetermined distance, wherein said predetermined distance is in the range of 10-100 µm, preferably 30 µm. Additionally, the step of creating a pattern in said raw printing plate may comprise removing said carbon layer by means of a laser, and said irradiation may be UV-light.

The method may further comprise a step of directly exposing the back side, i.e. the non-print side of said photopolymer layer to irradiation in order to harden said photopolymer layer on that side. This way, the bottom part of the raw printing plate, constituted by said photopolymer layer, may be hardened to provide the photopolymer plate with a stable bottom, thus controlling the maximum height of the relief pattern.

According to a second aspect of the invention, these and other objects are achieved in full, or at least in part, by a printing plate produced by a raw printing plate for flexographic printing. The raw printing plate comprises a photopolymer layer, and a carbon layer, said carbon layer having a through pattern. The raw printing plate is characterised in that said pattern has at least one roughened edge. The same advantages as described above apply for the raw printing plate.

The relief pattern may comprise two roughened edges arranged to face each other, wherein said two roughened edges are separated by a distance of 1-50 µm, preferably 10 µm. The relief pattern corresponding to the area between the two edges will be highly sensitive to dot gain. If the two edges are lines, a slightly too high pressure between the relief pattern and the material to be printed will lead to that the gap between the lines disappears.

According to a third aspect of the invention, these and other objects are achieved in full, or at least in part, by a printing process to enable better print quality control for flexographic printing. The printing process comprises the steps of printing a printing pattern onto a substrate using a printing plate according to the second aspect of the invention, detecting the dot gain of portions of the printing pattern corresponding to the parts of the relief having shallower shoulder, the shallow shoulders corresponding to the roughened edges in the carbon layer when manufacturing the printing plate, and adjusting the printing process in accordance to the detected dot gain.

The step of detecting the dot gain is preferably made automatically by a camera and image processing methods. If the step of detecting the dot gain is not automated it may performed manually by an operator.

The process provides a possibility for increased control of the printing process since the dot gain produced by the shallower shoulders (corresponding to the roughened edges) is much larger than for the normal relief pattern. If the pressure applied between the printing plate and the substrate that is to be printed is too high, the dot gain from the shallower shoulders will indicate an excess pressure and before the pressure is reached, at which the remaining relief pattern starts to show dot gain out of the ordinary.

According to a fourth aspect of the invention, these and other objects are achieved in full, or at least in part, by a printed substrate, such as packaging material, printed using the printing process according to the third aspect. The printed substrate or packaging material will thereby show an improved, higher quality of the printed pattern, with a more balanced and clear appearance, by avoiding excessive dot gain in relation to the relief pattern of the printing plate.

Generally, all terms used in the claims are to be interpreted according to their ordinary meaning in the technical field, unless explicitly defined otherwise herein. All references to "a/an/the [element, device, component, means, step, etc.]" are to be interpreted openly as referring to at least one instance of said element, device, component, means, step, etc., unless explicitly stated otherwise.

### Brief description of the drawings

The above objects, as well as additional objects, features and advantages of the present invention, will be more fully appreciated by reference to the following illustrative and non-limiting detailed description of preferred embodiments of the present invention, when taken in conjunction with the accompanying drawings, wherein:
Fig. 1a-f are schematic drawings of the process of flexographic printing.
Fig. 2a is a top view of a negative print pattern in a light stopping barrier layer, corresponding to the holes in Fig. 1a, according to a first embodiment of the invention.
Fig. 2b is a cross sectional side view of a relief object on the finished raw printing plate showing the shoulders created in the hardening process from the negative pattern shown in Fig. 2a.
Fig. 3a is a top view of a negative print pattern in a light stopping barrier layer according to a second embodiment of the invention.
Fig. 3b is a cross sectional side view of a relief object on the finished raw printing plate from the negative pattern shown in Fig. 3a.

### Detailed description of preferred embodiments of the invention

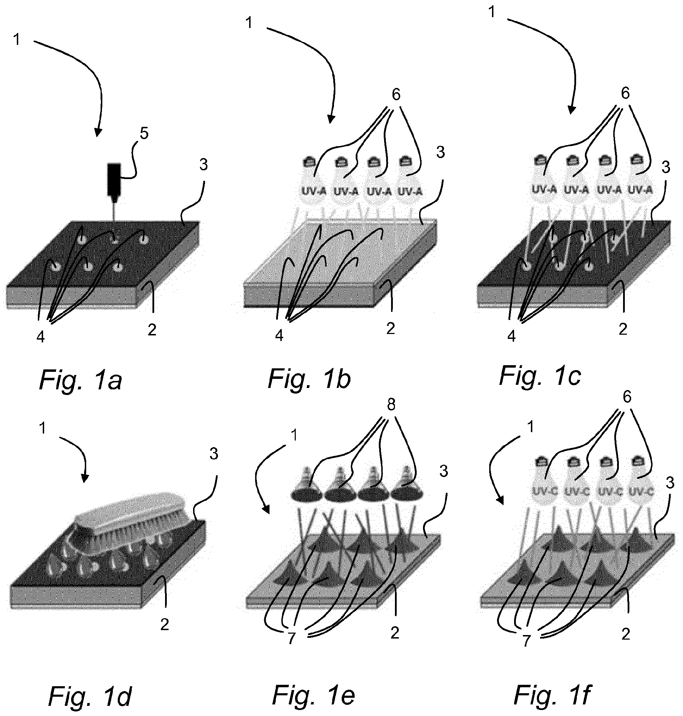

Fig. 1a-1f illustrate a method of producing a raw printing plate 1 for flexographic printing. Initially, the raw printing plate 1 comprises a photopolymer layer 2 and a carbon layer 3. The first step of the method is illustrated in Fig. 1a and consists of creating a pattern 4 in the carbon layer 3 of the raw printing plate 1 by partly removing the carbon layer 3 using a laser 5. In the second step, illustrated in Fig. 1b, the bottom part of the raw printing plate 1 is exposed to irradiation from a UV-light source 6 in order to harden the bottom portion of the photopolymer layer 2. Thereafter, the top part of the raw printing plate 1 is exposed to irradiation from the UV-light source 6. This means that the UV-light will hit the carbon layer 3 from above and in turn the top portion of the photopolymer layer 2, through said pattern 4, in order to harden the photopolymer (as illustrated in Fig. 1c) and create a relief pattern 7 therein. The pattern 4 created in the carbon layer 3 will determine the hardening area and accordingly the relief pattern 7 of the photopolymer layer 2. Thus, by configuring the pattern 4 of the carbon layer 3, different results can be achieved in regards to the relief pattern 7 of the photopolymer layer 2 when it comes to size and shape. In the next step, illustrated in Fig. 1d, the raw printing plate 1 is washed so that the carbon layer 3 as well as the portions of the photopolymer layer 2 not exposed to irradiation are removed so that the relief pattern 7 created in the photopolymer layer 2 will be created. Thereafter, the raw printing plate 1 is dried using heating lamps 8 (Fig. 1e) and finally hardened once again using UV-light (Fig. 1f).

The elements/objects in relief are elevated from the floor level on the photopolymer plate and the side walls or shoulders of these elevated elements have an angle, which angle level defines the total dot gain level. The steeper the angle (closest to vertical), the lower is the dot gain. The shallower the angle, the bigger the dot gain. Thus, in order to minimize dot gain the angle is made as steep as possible.

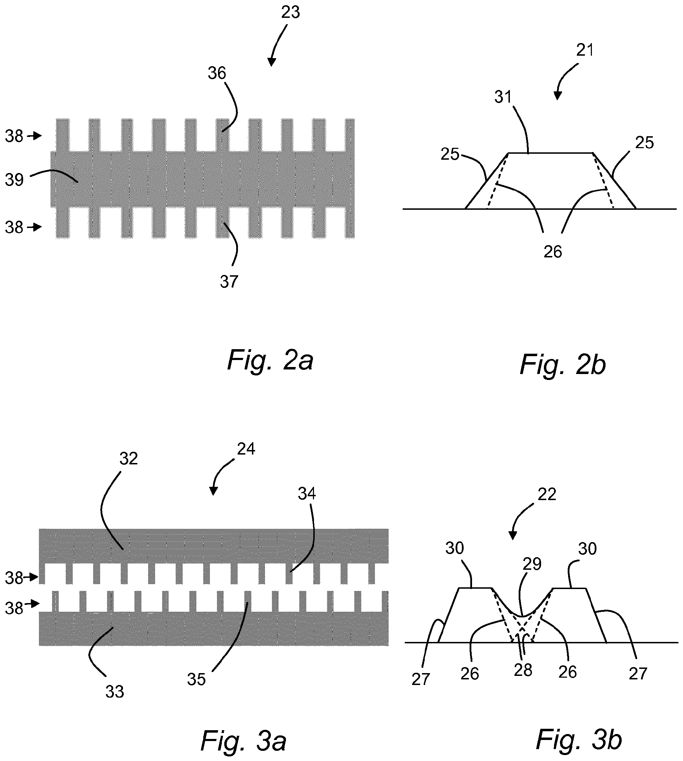

However, since the dot gain has a linear correlation to the impression, the level of dot gain can be used for impression control. With reference to Figs. 2b and 3b, impression control is created with an impression control pattern in the relief pattern on the polymer plate. In a full relief pattern on a raw printing plate, one or a few impression control objects 21, 22 are modified to have a greater sensitivity to dot gain than the normal print pattern. The impression control objects 21, 22 are created with shallow shoulders that react much more sensitively to the impression changes.

To create shallower shoulders in the impression control objects 21, 22, a special pattern 23, 24 is created in the light stopping layer before hardening of the polymer plate, shown in Figs. 2a and 3a. Some edges are made to have micro roughened edges 38 with extension portions in form of protruding lines 36, 37 extending from the edges 38. The micro roughened edges 38 will in the hardening process result in more light being able to pass the printed negative 23, 24 at the roughened edges, making these edges 38 to become shallower. In Fig. 2b the shallow shoulders 25 are seen. The dashed lines 26 indicate how the shoulder would have been shaped in absence of the protruding lines 36, 37 in the negative printing pattern.

To further enhance the effect of the shallower shoulders, two objects with opposing micro roughened edges may be used, e.g. two parallel lines with opposing micro roughened edges 38 as shown in Fig. 3a. The shallower shoulders will during the hardening process be united in a valley 29 between the print surfaces 30. In Fig. 3b, the dashed lines 26 indicate how the shoulders would have looked like without the micro roughened edges 38 and the dashed lines 28 indicate how the shallow shoulders would have looked like by themselves (i.e. if they would not have been placed close facing another shallow shoulder. The resulting impression control object 22 with a central valley 29 will be much more sensitive to elevated pressure resulting in dot gain being visible much sooner than for normal steep shoulders as the edges 27 in Fig. 3b.

In the micro roughened edges of Fig. 2a and 3a the extension portions or lines extending 34, 35, 36, 37 protrude in a direction substantially perpendicular to the edges of the objects 32, 33, 39. These lines 34, 35, 36, 37 each have a width of 5-25 µm, preferably 10 µm. The lines 34, 35, 36, 37 are separated by a predetermined distance in the range of 10-100 µm, preferably 30 µm and have length of 10-80 µm, preferably 40 µm. The two micro roughened edges of Fig. 3a are separated by a distance of 1-50 µm, preferably 10 µm, i.e. the distance from an end of a line 34 of one edge 38 of one object 32 to an end of another line 35 of another edge 38 of another object 33.

## Claims

1. Method for producing a printing plate for flexographic printing from a raw printing plate (1), said raw printing plate (1) comprising a photopolymer layer (2) and a carbon layer (3), wherein said method comprises the steps of:
creating a pattern (4) in said raw printing plate (1) by partly removing said carbon layer (3),
exposing said carbon layer (3) to irradiation to harden said photopolymer layer (2) in said pattern (4), and
removing said carbon layer (3) and portions of said photopolymer layer (2) not exposed to irradiation,
**characterised in that** at least a part of said pattern (4) has at least one roughened edge (38).

2. Method according to claim 1, wherein said at least one roughened edge (38) is constituted by an edge portion of said pattern (4) with a plurality of extension portions (36, 37) extending from said edge portion.

3. Method according to claim 2, wherein said plurality of extension portions (36, 37) comprise lines (36, 37) extending in a direction substantially perpendicular to said edge.

4. Method according to claim 3, wherein said lines (36, 37) each has a width of 5-25 µm, preferably 10 µm.

5. Method according to claim 3 or 4, wherein said lines (36, 37) are separated by a predetermined distance, wherein said predetermined distance is in the range of 10-100 µm, preferably 30 µm.

6. Method according to any one of claims 3-5, wherein said lines (36, 37) each has a length of 10-80 µm, preferably 40 µm.

7. Method according to any one of the preceding claims, wherein said step of creating a pattern (4) in said raw printing plate (1) comprises cutting said carbon layer (3) by means of a laser (5).

8. Method according to any one of the preceding claims, wherein said irradiation is UV-light.

9. Method according to any one of the preceding claims, further comprising the step of directly exposing said photopolymer layer (2) to irradiation to harden said photopolymer layer (2).

10. Raw printing plate (1) for flexographic printing, comprising
a photopolymer layer (2), and
a carbon layer (3), said carbon layer (3) having a through pattern (4),
**characterised in that** said pattern (4) has at least one roughened edge (38).

11. Raw printing plate (1) according to claim 10, wherein said pattern (4) comprises two roughened edges (38) arranged to face each other.

12. Raw printing plate (1) according to claim 11, wherein said two roughened edges (38) are separated by a distance of 1-50 µm, preferably 10 µm.

13. Printing plate (1) manufactured by the method according to any one of claims 1-9, wherein shoulders of the hardened printing pattern have a shallower slope at portions corresponding to the roughened edges (38) than shoulders corresponding to other edges.

14. Printing process to enable better print quality control for flexographic printing, said printing process comprising the steps of:
printing a printing pattern onto a substrate using a printing plate according to claim 13 or a printing plate manufactured from a raw printing plate according to any one of claims 10-12,
detecting the dot gain of portions of said printing pattern corresponding to said roughened edges (38), and
adjusting said printing process in accordance to said detected dot gain.

15. Printing process according to claim 14, wherein the step of detecting the dot gain is made automatically by a camera and image processing methods.

16. Use of a printing process according to claims 14 and 15 to provide a printed substrate, such as a packaging material.

## Patentansprüche

1. Verfahren zur Herstellung einer Druckplatte für Flexodruck aus einer Rohdruckplatte (1), wobei die Rohdruckplatte (1) eine Photopolymerschicht (2) und eine Kohlenstoffschicht (3) umfasst, wobei das Verfahren die folgenden Schritte umfasst:
Erzeugen eines Musters (4) in der Rohdruckplatte (1) durch teilweises Entfernen der Kohlenstoffschicht (3),
Belichten der Kohlenstoffschicht (3) mit Strahlung zum Härten der Photopolymerschicht (2) in dem Muster (4), und
Entfernen der Kohlenstoffschicht (3) und von Abschnitten der Photopolymerschicht (2), die nicht mit Strahlung belichtet sind,
**dadurch gekennzeichnet, dass** mindestens ein Teil des Musters (4) mindestens eine aufgeraute Kante (38) besitzt.

2. Verfahren nach Anspruch 1, wobei die mindestens eine aufgeraute Kante (38) durch einen Kantenabschnitt des Musters (4) mit mehreren Erweiterungsabschnitten (36, 37), die sich von dem Randabschnitt erstrecken, gebildet wird.

3. Verfahren nach Anspruch 2, wobei die mehreren Erweiterungsabschnitte (36, 37) Linien (36, 37) umfassen, die sich in einer Richtung im Wesentlichen senkrecht zu der Kante erstrecken.

4. Verfahren nach Anspruch 3, wobei die Linien (36, 37) jeweils eine Breite von 5-25 µm, bevorzugt 10 µm, besitzen.

5. Verfahren nach Anspruch 3 oder 4, wobei die Linien (36, 37) um eine vorbestimmte Distanz getrennt sind, wobei die vorbestimmte Distanz im Bereich von 10-100 µm liegt und bevorzugt 30 µm beträgt.

6. Verfahren nach einem der Ansprüche 3-5, wobei die Linien (36, 37) jeweils eine Länge von 10-80 µm, bevorzugt 40 µm, besitzen.

7. Verfahren nach einem der vorhergehenden Ansprüche, wobei der Schritt des Erzeugens eines Musters (4) in der Rohdruckplatte (1) das Schneiden der Kohlenstoffschicht (3) mit Hilfe eines Lasers (5) umfasst.

8. Verfahren nach einem der vorhergehenden Ansprüche, wobei die Bestrahlung UV-Licht ist.

9. Verfahren nach einem der vorhergehenden Ansprüche, weiterhin umfassend den Schritt des direkten Belichtens der Photopolymerschicht (2) mit Strahlung, um die Photopolymerschicht (2) zu härten.

10. Rohdruckplatte (1) für Flexodruck, umfassend:
eine Photoolymerschicht (2), und
eine Kohlenstoffschicht (3), wobei die Kohlenstoffschicht (3) ein durchgehendes Muster (4) besitzt,
**dadurch gekennzeichnet, dass** das Muster (4) mindestens eine aufgeraute Kante (38) besitzt.

11. Rohdruckplatte (1) nach Anspruch 10, wobei das Muster (4) zwei aufgeraute Kanten (38) umfasst, die so angeordnet sind, dass sie einander zugewandt sind.

12. Rohdruckplatte (1) nach Anspruch 11, wobei die zwei aufgerauten Kanten (38) mit einer Distanz von 1-50 µm, bevorzugt 10 µm, getrennt sind.

13. Druckplatte (1), hergestellt durch das Verfahren nach einem der Ansprüche 1-9, wobei Schultern des gehärteten Druckmusters eine flachere Steigung an Abschnitten entsprechend den aufgerauten Kanten (38) als anderen Kanten entsprechende Schultern besitzen.

14. Druckprozess zum Ermöglichen einer besseren Druckqualitätskontrolle für Flexodruck, wobei der Druckprozess die folgenden Schritte umfasst:
Drucken eines Druckmusters auf ein Substrat unter Verwendung einer Druckplatte nach Anspruch 13 oder einer aus einer Rohdruckplatte gemäß einem der Ansprüche 10-12 hergestellten Druckplatte,
Detektieren der Punktzunahme von Abschnitten des Druckmusters entsprechend den aufgerauten Kanten (38), und
Verstellen des Druckprozesses gemäß dem detektierten Punktzuwachs.

15. Druckprozess nach Anspruch 14, wobei der Schritt des Detektierens des Punktzuwachses automatisch durch eine Kamera und Bildverarbeitungsverfahren erfolgt.

16. Verwendung eines Druckprozesses nach Ansprüchen 14 und 15 zum Bereitstellen eines bedruckten Substrats wie etwa eines Packmaterials.

## Revendications

1. Procédé de production d'une plaque d'impression pour l'impression flexographique à partir d'une plaque d'impression brute (1), ladite plaque d'impression brute (1) comprenant une couche de photopolymère (2) et une couche de carbone (3), ledit procédé comprenant les étapes de :
création d'un motif (4) dans ladite plaque d'impression brute (1) par retrait partiel de ladite couche de carbone (3),
exposition de ladite couche de carbone (3) à une irradiation pour durcir ladite couche de photopolymère (2) dans ledit motif (4), et
retrait de ladite couche de carbone (3) et de portions de ladite couche de photopolymère (2) non exposées à l'irradiation,
**caractérisé en ce qu'**au moins une partie dudit motif (4) a au moins un bord rugosifié (38).

2. Procédé selon la revendication 1, dans lequel ledit au moins un bord rugosifié (38) est constitué d'une portion de bord dudit motif (4) avec une pluralité de portions de prolongement (36, 37) se prolongeant depuis ladite portion de bord.

3. Procédé selon la revendication 2, dans lequel ladite pluralité de portions de prolongement (36, 37) comprend des lignes (36, 37) se prolongeant dans une direction sensiblement perpendiculaire audit bord.

4. Procédé selon la revendication 3, dans lequel lesdites lignes (36, 37) ont chacune une largeur de 5-25 µm, de préférence 10 µm.

5. Procédé selon la revendication 3 ou 4, dans lequel lesdites lignes (36, 37) sont séparées par une distance prédéterminée, ladite distance prédéterminée se situant dans la gamme de 10-100 µm, de préférence 30 µm.

6. Procédé selon l'une quelconque des revendications 3 à 5, dans lequel lesdites lignes (36, 37) ont chacune une longueur de 10-80 µm, de préférence 40 µm.

7. Procédé selon l'une quelconque des revendications précédentes, dans lequel ladite étape de création d'un motif (4) dans ladite plaque d'impression brute (1) comprend la découpe de ladite couche de carbone (3) au moyen d'un laser (5).

8. Procédé selon l'une quelconque des revendications précédentes, dans lequel ladite irradiation est un rayonnement UV.

9. Procédé selon l'une quelconque des revendications précédentes, comprenant en outre l'étape d'exposition directe de ladite couche de photopolymère (2) à une irradiation pour durcir ladite couche de photopolymère (2) .

10. Plaque d'impression brute (1) pour l'impression flexographique, comprenant
une couche de photopolymère (2), et
une couche de carbone (3), ladite couche de carbone (3) ayant un motif traversant (4),
**caractérisée en ce que** ledit motif (4) a au moins un bord rugosifié (38).

11. Plaque d'impression brute (1) selon la revendication 10, dans laquelle ledit motif (4) comprend deux bords rugosifiés (38) disposés pour se faire face.

12. Plaque d'impression brute (1) selon la revendication 11, dans laquelle lesdits deux bords rugosifiés (38) sont séparés par une distance de 1-50 µm, de préférence 10 µm.

13. Plaque d'impression (1) fabriquée par le procédé selon l'une quelconque des revendications 1 à 9, dans laquelle des épaulements du motif d'impression durci ont une pente au niveau de portions correspondant aux bords rugosifiés (38) plus douce que des épaulements correspondant aux autres bords.

14. Procédé d'impression pour permettre un meilleur contrôle de la qualité d'impression pour l'impression flexographique, ledit procédé d'impression comprenant les étapes de :
impression d'un motif d'impression sur un substrat au moyen d'une plaque d'impression selon la revendication 13 ou d'une plaque d'impression fabriquée à partir d'une plaque d'impression brute selon l'une quelconque des revendications 10 à 12,
détection de l'élargissement du point de portions dudit motif d'impression correspondant auxdits bords rugosifiés (38), et
réglage dudit procédé d'impression en fonction dudit élargissement du point détecté.

15. Procédé d'impression selon la revendication 14, dans lequel l'étape de détection de l'élargissement du point est réalisée automatiquement par une caméra et des procédés de traitement d'image.

16. Utilisation d'un procédé d'impression selon les revendications 14 et 15 pour l'obtention d'un substrat, tel qu'un matériau d'emballage, imprimé.
